# EUROPEAN PATENT SPECIFICATION

(11) **EP 1 302 810 B1**
(45) Date of publication and mention of the grant of the patent: **28.11.2007**
(21) Application number: 02252247.8
(22) Date of filing: 27.03.2002
(51) Int. Cl.: G02F 1/39, G02F 1/355, H01L 31/0352, H01S 5/343, H01L 29/12

(54) **Photosemiconductor device and method for fabricating the same**
Photohalbleitervorrichtung und Herstellungsverfahren
Dispositif optique à semiconducteur et méthode de fabrication

(30) Priority: 09.10.2001 JP 2001311046
(43) Date of publication of application: 16.04.2003
(73) Proprietor: FUJITSU LIMITED, Kawasaki-shi, Kanagawa 211-8588 (JP)
(72) Inventor: Akiyama, Tomoyuki, Nakahara-ku, Kawasaki-shi, Kanagawa 211 (JP)
(74) Representative: Fenlon, Christine Lesley

(56) References cited:
- US-A- 5 936 258
- ISHIKAWA H ET AL: "Self-organized quantum dots and quantum dot lasers (invited)" JOURNAL OF VACUUM SCIENCE AND TECHNOLOGY A. VACUUM, SURFACES AND FILMS, AMERICAN INSTITUTE OF PHYSICS, NEW YORK, NY, US, vol. 16, no. 2, March 1998 (1998-03), pages 794-800, XP012003859 ISSN: 0734-2101
- BHATTACHARYA P ET AL: "IN(GA)AS/GAAS SELF-ORGANIZED QUANTUM DOT LASERS: DC AND SMALL-SIGNAL MODULATION PROPERTIES" IEEE TRANSACTIONS ON ELECTRON DEVICES, IEEE INC. NEW YORK, US, vol. 46, no. 5, May 1999 (1999-05), pages 871-883, XP000928581 ISSN: 0018-9383
- ARAKAWA Y ET AL: "GROWTH AND OPTICAL PROPERTIES OF SELF-ASSEMBLED QUANTUM DOTS FOR SEMICONDUCTOR LASERS WITH CONFINED ELECTRONS AND PHOTONS" IEICE TRANSACTIONS ON ELECTRONICS, INSTITUTE OF ELECTRONICS INFORMATION AND COMM. ENG. TOKYO, JP, vol. E79-C, no. 11, November 1996 (1996-11), pages 1487-1493, XP000681546 ISSN: 0916-8524

## Description

The present invention relates to a photosemiconductor device and a method for fabricating the photosemiconductor device, more specifically to a photosemiconductor device having quantum dots and a method for fabricating the photosemiconductor device.

Semiconductor light amplifiers and semiconductor lasers are small-sized and have small electric power consumptions, which makes them attractive in the field of optical communication.

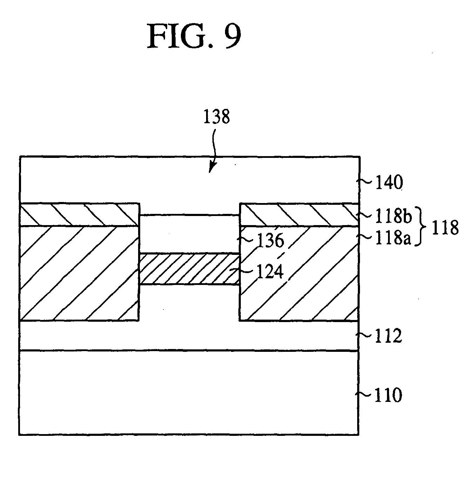

A conventional semiconductor light amplifier will be explained with reference to FIG. 9. FIG. 9 is a sectional view of the conventional semiconductor light amplifier.

As shown in FIG. 9, a covering layer 112 of n type InP is formed on a semiconductor substrate 110 of n type InP. A bulk active layer 124 of InGaAs is formed on the covering layer 112. A covering layer 136 is formed on the bulk active layer 124. The covering layer 136, the bulk active layer 124 and the covering layer 112 are formed in a mesa as a whole and form a mesa-shaped light waveguide layer 138. A current constriction layer 118 is formed of a p type InP layer 118a and an n type InP layer 118b on both sides of the light waveguide layer 138. A cap layer 140 is formed of n type InP on the light waveguide layer 138 and the current constriction layer 118. AR (Anti-Reflection) coat film (not shown) is formed on both sides of the mesa-shaped light waveguide layer 138. The conventional semiconductor light amplifier has such a structure.

The use of a quantum well active layer in place of the bulk active layer 124 is also proposed. The use of the quantum well active layer can improve gain bandwidth in comparison with the use of the bulk active layer.

However, the gain bandwidth of the conventional semiconductor light amplifier using the bulk active layer and the quantum well active layer is small. Accordingly, the conventional semiconductor light amplifier cannot amplify a WDM (Wavelength Division Multiplexing) signal of a wide band at once.

Here, injecting more current into the bulk active layer and the quantum well active layer increases the numbers of electrons and holes stored in the bulk active layer and the quantum active layer, which will widen the gain bandwidth. However, the increase of the injected current to the bulk active layer and the quantum well active layer increases calorific energy, and the temperatures of the bulk active layer and the quantum well active layer rise. Thus, there is a limit to widening the gain bandwidth by injecting more current into the bulk active layer and the quantum well active layer.

Decreasing the thickness of the bulk active layer or decreasing the layer number of the quantum well active layer decreases the density state of carriers per a unit area of the current injection region, whereby the Fermi level may be transferred to a higher energy side, and the gain bandwidth may be widened. However, even decreasing, e.g., the layer number of the quantum well active layer to one layer will widen the gain bandwidth to about 70 nm at maximum.

Here, a high reflection film (not shown) is formed on both side surfaces of the mesa-shaped light waveguide layer 138 to thereby form a semiconductor laser. However, the conventional semiconductor lasers using the bulk active layer and the quantum well active layer have narrow gain bandwidths and accordingly narrow wavelength variable ranges.

An object of the present invention is to provide a photosemiconductor device of a wide gain bandwidth, and a method for fabricating the photosemiconductor device.

According to one aspect of the present invention, there is provided a photosemiconductor device comprising a plurality of quantum dots, the plurality of quantum dots having non-uniform sizes, and being in three-dimensionally grown islands self-formed by S-K mode; characterised in that when the area of a current injection region is A, and the total area of the plurality of quantum dots is B, the area ratio B/A of the plural quantum dots is 0.4 or less.

According to another aspect of the present invention, there is provided a method for fabricating a photosemiconductor device comprising the step of: forming a plurality of quantum dots of non-uniform size over a semiconductor substrate, the plural quantum dots being self-formed in three-dimensionally grown islands by S-K mode; characterised in that the plurality of quantum dots are formed so that when the area of a current injection region is A, and the total of area of the plurality of quantum dots is B, the area ratio B/A of the plural quantum dots is 0.4 or less.

As described above, according to the present invention, quantum dots of non-uniform sizes are formed with a low area ratio, whereby the photosemiconductor device can have a wide gain bandwidth.

Quantum dot lasers comprising self-formed quantum dots are known from the articles "Self-Organised Quantum Dots and Quantum Dot Lasers" by H. Ishikawa et al, pp 794-800, J. Vac. Sci. TechnologyA 16 (2), Mar/Apr 1998, "In (Ga) As/GaAs Self-Organised Quantum Dot Lasers: DC and Small-Signal Modulation Properties" by P. Bhattacharya et al, IEEE Transactions on Electron Devices", vol. 46, no. 5, May 1999, pp 871-883, and "Growth and Optical Properties of Self-Assembled Quantum Dots for Semiconductor Lasers with Confined Electrons and Photons", IEICE Transactions in Electronics, vol. E. 79-C, No. 11, November 1996, pp 1487-1493.

For a better understanding of the present invention, reference will now be made, by way of example, to the accompanying drawings wherein:-
FIG. 1 is a graph showing density of states in the active layer.
FIG. 2 is a graph showing density of states and carrier densities.
FIG. 3 is a graph showing gain coefficients and population inversion coefficients.
FIG. 4 is a sectional view of the photosemiconductor device according to one embodiment of the present invention.
FIG. 5 is a plan view of the quantum dots of the photosemiconductor device according to the one embodiment of the present invention.
FIG. 6 is a graph showing a gain spectrum of the photosemiconductor device according to the one embodiment of the present invention.
FIGS. 7A-7C and 8A-8C are sectional views of the photosemicondcutor device according to one embodiment of the present invention showing the steps of the method for fabricating the photosemiconductor device.
FIG. 9 is a sectional view of a conventional semiconductor light amplifier according to the prior art.

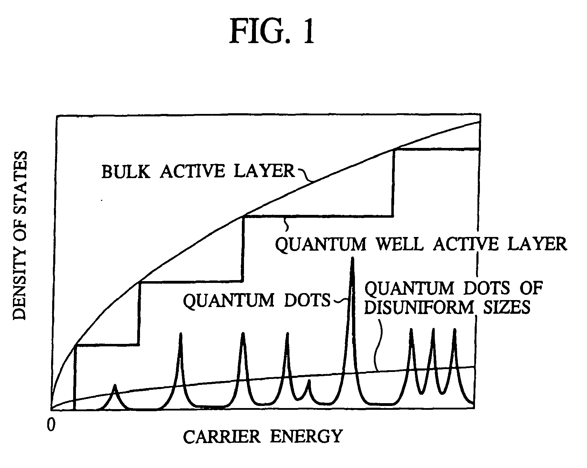

First, the principle of the present invention will be explained with reference to FIGs. 1 to 3.

In FIG. 1, energies of the carrier are presented on the horizontal axis, and densities of state in the active layer are presented on the vertical axis.

As shown in FIG. 1, densities of state in the bulk active layer have a smooth distribution in which the densities of state are proportional to square roots of the carrier energy. The densities of state in the quantum well active layer have a stepped distribution.

For a wide gain bandwidth in the photosemiconductor device, the density of state in the active layer will be set to be low. In order to set low the density of state in the bulk active layer, the bulk active layer will be made thin. In order for the density of state of the carriers in the quantum well active layer to be low, the number of layers of the quantum well active layer will be made small. However, as described above, even a decrease in the layer number of the quantum well active layer to one layer will widen a gain bandwidth to about 70 nm at maximum. A sufficiently wide gain width cannot be obtained.

Here, quantum dots will be used as the active layer. The use of quantum dots as the active layer makes it possible to decrease the density of state in a current injection region within a unit area, thus making it possible to widen a gain bandwidth without increasing the injected current into the active layer.

However, when quantum dots are merely used as the active layer, the density of state distribution has some gain peaks as shown in FIG. 1. Based on this, the mere use of quantum dots will not provide a photosemiconductor device having good gain characteristics.

The inventors of the present application made earnest studies and have realised that quantum dots are formed in non-uniform sizes to thereby obtain a smooth density of state distribution like that of the carriers in the bulk active layer. Quantum dots formed in non-uniform sizes interconnect the gain peaks of respective energy levels appearing in the density of state distribution in the case that quantum dots are formed in a uniform size.

In the specification of the present application, a current injection region does not mean an entire region with an electrode (not shown) for injecting current formed in it, but means a region where current restricted by the current constriction layer is actually injected into the active layer.

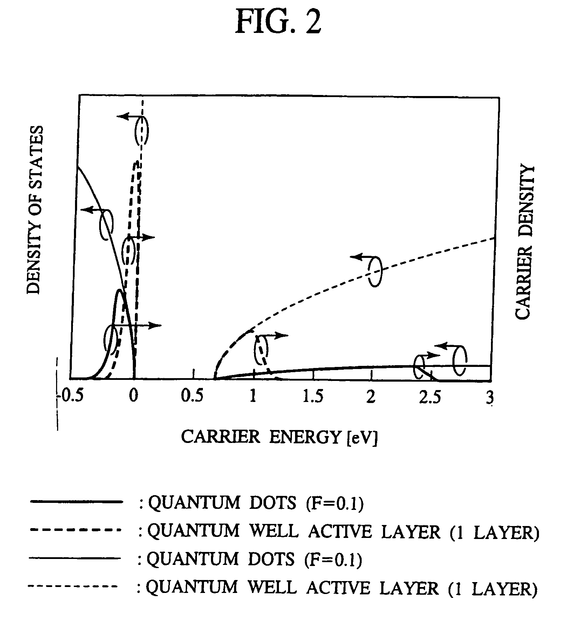

In FIG. 2, the energies of the carriers are presented on the horizontal axis, and the densities of state and carrier densities are presented on the vertical axis.

In FIG. 2, the thin broken line indicates densities of state per unit area of the current injection region in the case that the layer number of the quantum well active layer is one. As indicated by the thin broken line in FIG. 2, in the case of the quantum well active layer, densities of state are relatively high in relation to the unit area of the current injection region.

The thin solid line in FIG. 2 indicates densities of state in relation to the unit area of the current injection region in the case that quantum dots of non-uniform sizes are formed in an area ratio F of 0.1. As indicated by the thin solid line in FIG. 2, in the case that quantum dots of non-uniform sizes are formed by an area ratio F of 0.1, densities of state of the carriers per unit area of the current injection region are about 1/10 those of the case where the layer number of the quantum well active layer is one layer.

Here, the area ratio F of the quantum dots is the ratio B/A wherein A is an area of the current injection region, and B is the total area of a plurality of quantum dots formed in the current injection region. The layer number of the quantum dots is not essentially 1, and the quantum dots may be formed over a plurality of layers. When the quantum dots are formed over two layers, the total area of the quantum dots formed in one layer in the current injection region is B₁, and a total area of quantum dots formed in the second layer in the current injection region is B₂, an area ratio F of the quantum dots is expressed by (B₁ + B₂) /A. In the case that the quantum dots are formed over n layers, when the total area of the quantum dots formed in the n-th layer in the current injection region is Bₙ, the area ratio F of the quantum dots is expressed by (B₁ + B₂ + .... + Bₙ)/A. When the area ratio F of the quantum dots is 1, the density of state per unit area in the current injection area substantially agrees with the densities of state per unit area in the current injection region in the case that the layer number of the quantum well active layer is 1.

When current is injected into the active layer, carriers, i.e., electrons and holes, are stored in the conduction band and the valence band in accordance with Fermi distribution.

In FIG. 2, the thick broken line indicates carrier densities in the current injection region in the case that the layer number of the quantum well active layer is 1. As indicated by the thin broken line in FIG. 2, in the case of the quantum well active layer, the densities of state per unit area in the current injection region are relatively high. Accordingly, as indicated by the thick broken line in FIG. 2, the energy distribution of the carriers is relatively narrow.

In FIG. 2, the thick solid line indicates carrier densities in the current injection region in the case that the quantum dots of non-uniform sizes are formed by an area ratio F of 0.1. As indicated by the thin solid line in FIG. 2, in the case that the quantum dots of non-uniform sizes are formed by an area ratio F of 0.1, the densities of state of the carriers in each unit area in the current injection region are low. Accordingly, as indicated by the thick solid line in FIG. 2, the energy distribution of the carriers is very wide.

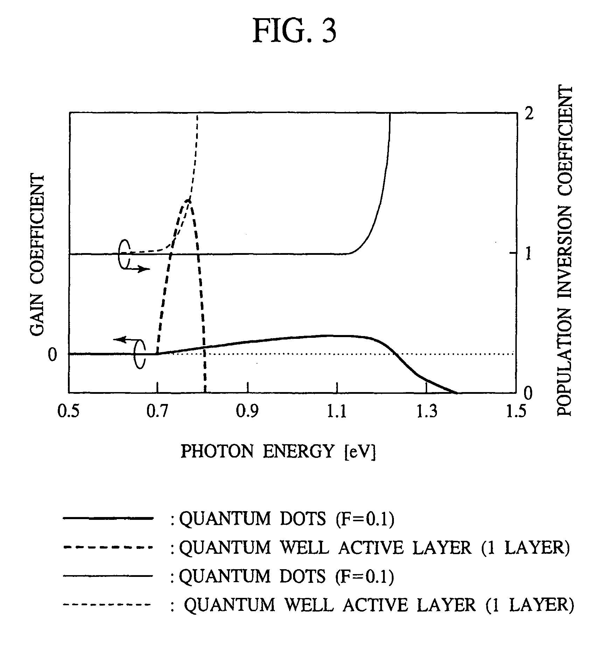

In FIG. 3 energies of photons are presented on the horizontal axis, and gain coefficients and population inversion coefficients are presented on the vertical axis.

The thick broken line in FIG. 3 indicates the gain coefficient in the case that the layer number of the quantum well active layer is 1. The gain coefficient is given by dP/dZ=gP wherein P is the power of light, and Z is the propagation direction. As indicated by the thick broken line in FIG. 3, in the case of the quantum well active layer, even when the layer number is 1, the width of the gain spectrum is relatively narrow.

In FIG. 3, the thick solid line indicates gain coefficients in the case that the quantum dots of non-uniform sizes are formed in an area ratio F of 0.1. As indicated by the thick solid line in FIG. 3, when the quantum dots of a uniform size are formed in an area ratio F of 0.1, the width of the gain spectrum is very wide.

Thus, it is found that the quantum dots of non-uniform sizes are formed by a low area ratio F, whereby a photosemiconductor device having a wide gain band is provided.

The thin broken line in FIG. 3 indicates population inversion coefficients in the case that the layer number of the quantum well active layer is 1. As indicated by the thin broken line in FIG. 3, in the case of the quantum well active layer, the energy range of small population inversion coefficients is relatively narrow.

The population inversion coefficient is expressed by F_{c}/(F_{c} - Fᵥ) where an abundance probability of electrons in the conduction band is F_{c}, and an abundance probability of electrons in the valence band is Fᵥ. As the energy range of small population inversion coefficients becomes wider, the noise characteristics improve.

The thin solid line in FIG. 3 indicates population inversion coefficients in the area that the quantum dots of non-uniform sizes are formed in an area ratio F of 0.1. As indicated by the thin solid line in FIG. 3, in the case that quantum dots of non-uniform sizes are formed by an area ratio F of 0.1, the energy range of small population inversion coefficients becomes very wide.

Thus, it is found that quantum dots of non-uniform sizes are formed with a low area ratio F, whereby a photosemiconductor device having good noise characteristics is provided.

As described above, the quantum dots of non-uniform sizes are formed in a low area ratio F, whereby a photosemiconductor device having a wide gain band and good noise characteristics are provided without increasing current injection into the active layer.

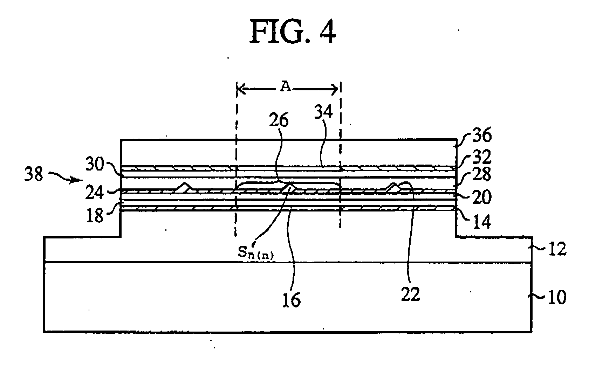

The photosemiconductor device according to one embodiment of the present invention and the method for fabricating the semiconductor device will be explained with reference to FIGs. 4 to 8C.

In the present embodiment, the principle of the present invention is applied to a semiconductor light amplifier. However, the principle of the present invention is not limited to the application to semiconductor light amplifiers and is applicable to any other photosemiconductor devices, such as semiconductor lasers.

### (Photosemiconductor Device)

As shown in Fig. 4, a covering layer 12 of n type Al_{0.4}Ga_{0.6}As is formed on a semiconductor substrate 10 of n type GaAs.

A current constriction layer 14 of Al₂O₃ and a current pass layer 16 of AlAs are formed on the covering layer 12.

An n type Al_{0.4}Ga_{0.6}As layer 18 is formed on the current constriction layer 14 and the current pass layer 16.

An SCH (Separate Confinement Heterostructure) layer 20 of GaAs is formed on the n type Al_{0.4}Ga_{0.6}As layer 18.

An InAs layer 24 comprising a plurality of self-formed quantum dots of non-uniform sizes is formed on the SCH layer 20. The quantum dots 22 can be formed in, e.g., Stranski-Krastanow mode (hereinafter called "S-K mode"). In S-K mode, semiconductor crystals to be epitaxially grown grow two-dimensionally (in film) at the start of the growth and grow three dimensionally when the growth has exceeded the elastic limit of the film. To self-form the quantum dots 22 in three-dimensionally grown islands by S-K mode, it is required to form a film of a larger lattice constant than the material of the base film. S-K mode, which can easily facilitate the self-formation, is generally used.

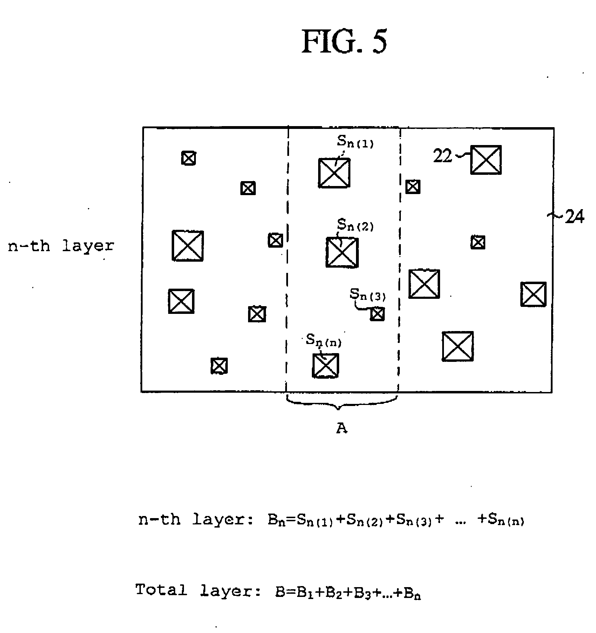

As shown in FIG. 5, the quantum dots 22 have non-uniform sizes. The sizes of the quantum dots 22 are made non-uniform so as to obtain a smooth density of state distribution as described above.

The area ratio F of the quantum dots 22 is, e.g., 0.1. This is because when the area radio F of the quantum dots 22 is as low as 0.1, as described above, the photosemiconductor device can have a wide gain bandwidth.

The area ratio F of the quantum dots 22 is not essentially limited to 0.1. For example, an area ratio F of the quantum dots 22 can be suitably set within a range of less than 1 excluding 1. Making an area ratio F of the quantum dots 22 less than 1 excluding 1 makes it possible to make the density of state per unit area in the current injection region 26 lower than that when the layer number of the quantum well active layer is 1. Accordingly, making an area ratio of the quantum dots 22 less than 1 makes it possible to make the gain band wider than at least that of the case that the layer number of the quantum well active layer is 1.

It is more preferable to set the area ratio F of the quantum dots 22 to be 0.4 or less. Making an area ratio F of the quantum dots 22 to be 0.4 or less can more widen the gain bandwidth.

Furthermore, preferably the area ratio F of the quantum dots 22 is set to be about 0.1. The area ratio F of the quantum dots 22 is set to be as low as about 0.1, whereby the gain band can be much wider.

An SCH layer 28 of GaAs is formed on the InAs layer 24.

Ap type Al_{0.4}Ga_{0.6}As layer 30 is formed on the SCH layer 28.

A current constriction layer 32 of Al₂O₃ and a current pass layer 34 of AlAs are formed on the p type Al_{0.4}Ga_{0.6}As layer 30.

A covering layer 36 of p type Al_{0.4}Ga_{0.6}As is formed on the current constriction layer 32 and the current pass layer 34.

The layer films of the covering layer 36, the current constriction layer 32, the p type Al_{0.4}Ga_{0.6}As layer 30, the SCH layer 28, InAs layer 24, the SCH layer 20, n type Al_{0.4}Ga_{0.6}As layer 18, the current constriction layer 14 and the covering layer 12 is etched generally into a mesa shape. Thus, a light waveguide layer 38 is formed.

An AR coat film (not shown) is formed on both end surfaces of the light waveguide layer 38.

The photosemiconductor device according to the present embodiment is characterized mainly in that the quantum dots 22 of non-uniform sizes are formed by a low area ratio F.

According to the present embodiment, the active layer is provided by the quantum dots 22, and an area ratio F of the quantum dots 22 is set low, with the density of state in each unit area in the current injection region 26 being able to be low. According to the present embodiment, the quantum dots 22 are formed in non-uniform sizes, whereby a blunt density of state distribution can be obtained. Thus, the photosemiconductor device according to the present embodiment can have a wide gain bandwidth and good noise characteristics.

Reducing the area ratio F of the quantum dots 22 generally reduces the gain. However, making the light waveguide layer 38 longer can ensure sufficient gains.

### (Evaluation Result)

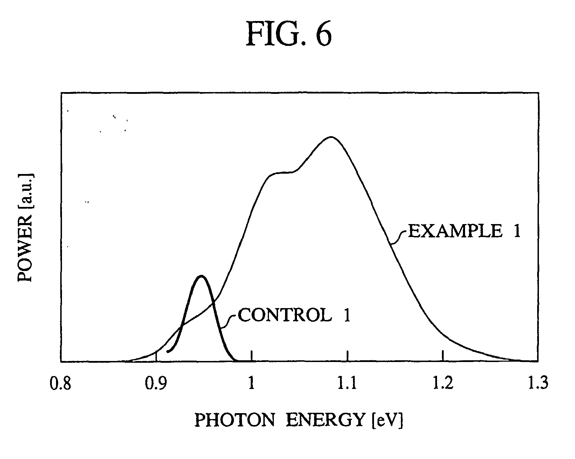

In Fig. 6, the energies of photons are presented on the horizontal axis, and powers are presented on the vertical axis. Example 1 indicates the gain spectrum of a photosemiconductor device according to the present embodiment, specifically a gain spectrum of the case that an area ratio F of the quantum dots is 0.1. Control 1 indicates the gain spectrum of the photosemiconductor device in the case that the layer number of the quantum well active layer is 1.

As indicated by Control 1, in the photosemiconductor device using the quantum well active layer, a half-width of the peak value of the gain spectrum is about 0.03 eV, which is relatively narrow.

In contrast to this, in the photosemiconductor device according to the present embodiment, continuous spectra are obtained in the range of 0.9 eV to 1.2 eV. The half-width of the peak of the gain spectrum is 0.17 eV, which is very wide.

Thus, according to the present embodiment, the gain band can be as wide as about 400nm to 600 nm. The photosemiconductor device according to the present embodiment can have a very wide gain band which extends to above 50 THz. Thus, according to the present embodiment, WDM signals of wide bands can be amplified at once by a photosemiconductor device, thereby contributing to drastic simplification of the systems and lower costs.

### (Method for Fabricating the Photosemiconductor Device)

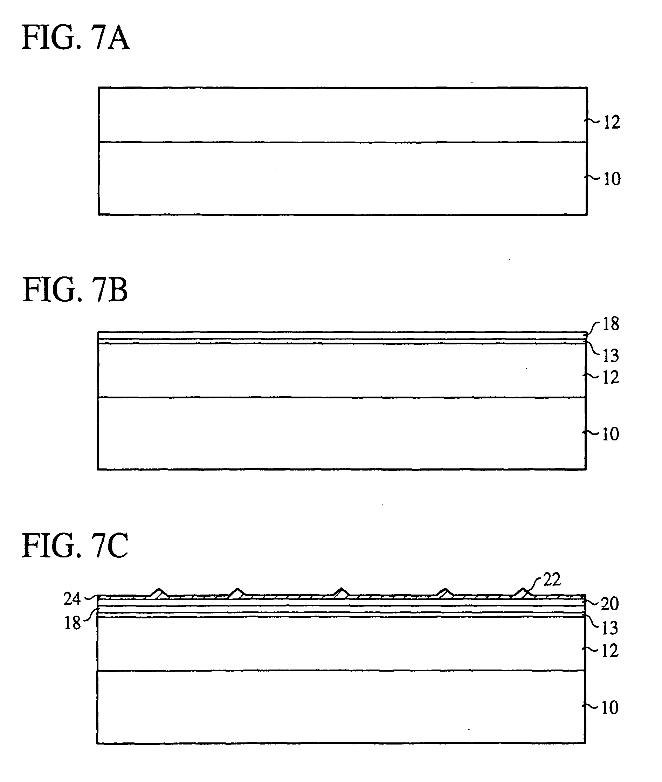

As shown in FIG. 7A, the covering layer 12 of n type Al_{0.4}Ga_{0.6}As is formed in a 1200 nm-thickness by MBE (Molecular Beam Epitaxial Growth) on the entire surface of a semiconductor substrate 10 of n type GaAs.

Then, as shown in FIG. 7B, an AlAs layer 13 is formed in a 80 nm-thickness on the entire surface by MBE.

Then, the n type Al_{0.4}Ga_{0.6}As layer 18 is formed in a 150 nm-thickness on the entire surface by MBE.

Next, as shown in FIG. 7C, the SCH layer 20 of GaAs is formed in a 100 nm-thickness on the entire surface by MBE.

Then, the InAs layer 24 is formed on the entire surface by MBE. Because InAs has a larger lattice constant than GaAs forming the SCH layer 20, the quantum dots 22 can be self-formed by S-K mode. Conditions for forming the InAs layer 24 are a substrate temperature of, e.g., 510 °C, an InAs feed amount of, e.g., 1.5 ml and a growth time of, 250 seconds. The InAs layer 24 grown under these conditions have an area ratio F of, e.g., about 0.1, and the quantum dots 22 have non-uniform sizes.

The conditions for forming the quantum dots 22 of non-uniform sizes are not limited to the above. Sizes of the quantum dots 22 tend to be non-uniform when a growth rate is made high, and substrate temperature is low. The growth rate for forming the InAs layer 24 is reduced, feed amounts of the raw materials of the InAs layer 24 are decreased, and substrate temperature is made high, with the area ratio F of the quantum dots 22 tending to be low. Accordingly, growth rate and raw material feed amounts of the InA layer 24, substrate temperature, etc. are suitably set, whereby the quantum dots 22 of non-uniform sizes can be formed in a required area ratio F.

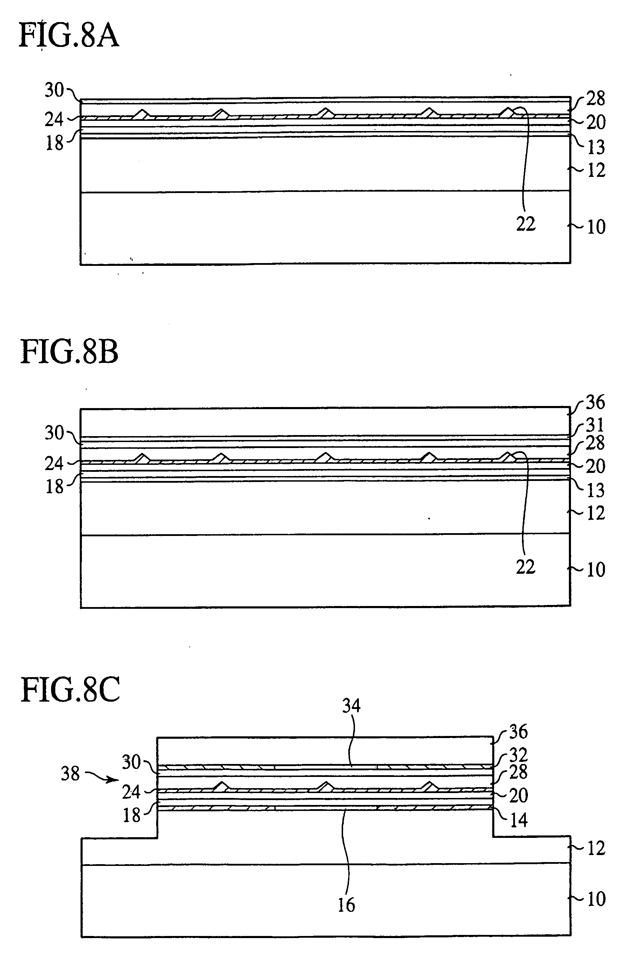

Then, as shown in FIG. 8A, the SCH layer 28 of GaAs is formed in a 100 nm-thickness on the entire surface by MBE.

Next, the p type Al_{0.4}Ga_{0.6}As layer 30 is formed in a 150 nm-thickness on the entire surface by MBE.

Next, as shown in FIG. 8B, the AlAs layer 31 of a 80 nm-thickness is formed on the entire surface by MBE.

Then, the covering layer 36 of p type Al_{0.4}Ga_{0.6}As is formed in a 1200 nm-thickness on the entire surface by MBE.

Next, as shown in FIG. 8C, the layer film of the covering layer 36, AlAs layer 31, the p type Al_{0.4}Ga_{0.6}As layer 30, the SCH layer 28, InAs layer 24, the SCH layer 20, n type Al_{0.4}Ga_{0.6}As layer 18, the AlAs layer 13 and the covering layer 12 are etched into a mesa shape. A light waveguide layer 38 is thus formed.

Then, the AlAs layers 13, 31 are oxidized at the part of the light waveguide layer 38 except for the central part thereof to form the current constriction layers 14, 32 of Al₂O₃. The AlAs layers 13, 31 at the part which has not been oxidized become the current pass layers 16, 34.

Then, an AR coating film (not shown) is formed on both end surfaces of the light waveguide layer 38.

Thus, a photosemiconductor device according to the present invention is fabricated.

### [Modifications]

The present invention is not limited to the above-described embodiment and can cover other various modifications.

For example, in the above-described embodiment, the principle of the present invention is applied to the semiconductor light amplifier. The principle of the present invention is applicable, as described above, not only to semiconductor light amplifiers but also to any other photosemiconductor devices, such as semiconductor lasers. When the principle of the present invention is applied to semiconductor lasers, the semiconductor lasers can have wide variable wavelength range.

In the above-described embodiment, the quantum dots are formed in one layer. However, the quantum dots are not formed essentially in one layer and may be formed over a plurality of layers.

In the above-described embodiment, the material of the semiconductor substrate is a GaAs-based material. However, the material of the semiconductor substraste, etc. is not limited to GaAs-based materials and can be an InP-based material.

## Claims

1. A photosemiconductor device comprising a plurality of quantum dots (22),
the plurality of quantum dots (22) having non-uniform sizes, and being in three-dimensionally grown islands self-formed by S-K mode;
**characterised in that** when the area of a current injection region (26) is A, and the total area of the plurality of quantum dots (22) is B, the area ratio B/A of the plural quantum dots (22) is 0.4 or less.

2. A photosemiconductor device according to claim 1, wherein the area ratio B/A of the plural quantum dots (22) is 0.1.

3. A photosemiconductor device according to claim 1 or 2 wherein
the quantum dots (22) are formed on an SCH layer (20); and
the lattice constant of a material of the quantum dots (22) is larger than that of a material of the SCH layer (20).

4. A photosemiconductor device according to claim 1, 2 or 3, wherein
the quantum dots (22) are formed of InAs; and
the SCH layer (20) is formed of GaAs.

5. A photosemiconductor device according to any preceding claim, wherein
the quantum dots (22) are an active layer of a semiconductor light amplifier.

6. A photosemiconductor device according to any one of claims 1 to 4, wherein
the quantum dots (22) are an active layer of a semiconductor laser.

7. A method for fabricating a photosemiconductor device comprising the step of:
forming a plurality of quantum dots (22) of non-uniform size over a semiconductor substrate (10), the plural quantum dots (22) being self-formed in three-dimensionally grown is lands by S-K mode;
**characterised in that** the plurality of quantum dots (22) are formed so that when the area of a current injection region (26) is A, and the total of area of the plurality of quantum dots (22) is B, the area ratio B/A of the plural quantum dots (22) is 0.4 or less.

8. A method for fabricating a photosemiconductor device according to claim 7, wherein
in the step of forming a plurality of quantum dots (22), the plurality of quantum dots is formed so that the area ratio B/A of the plural quantum dots (22) is 0.1.

9. A method for fabricating a photosemiconductor device according to claim 7 or 8, further comprising the step of:
forming an SCH layer (20) of a material having a lattice constant smaller than that of the quantum dots (22) over the semiconductor substrate (10) before the step of forming quantum dots (22).

## Patentansprüche

1. Photohalbleitervorrichtung, die mehrere Quantenpunkte (22) umfasst,
wobei die mehreren Quantenpunkte (22) ungleichmäßige Größen aufweisen und in dreidimensional gewachsenen Inseln durch einen S-K-Modus selbstgebildet sind,
**dadurch gekennzeichnet, dass**, wenn die Fläche eines Strominjektionsbereichs (26) A ist und die Gesamtfläche der mehreren Quantenpunkte (22) B ist, das Flächenverhältnis B/A der mehreren Quantenpunkte (22) 0,4 oder weniger beträgt.

2. Photohalbleitervorrichtung nach Anspruch 1, bei der das Flächenverhältnis B/A der mehreren Quantenpunkte (22) 0,1 beträgt.

3. Photohalbleitervorriehtung nach Anspruch 1 oder 2, bei der
die Quantenpunkte (22) auf einer SCH-Schicht (20) ausgebildet sind und
die Gitterkonstante eines Materials der Quantenpunkte (22) größer als die eines Materials der SCH-Schicht (20) ist.

4. Photohalblcitervorrichtung nach Anspruch 1, 2 oder 3, bei der
die Quantenpunkte (22) aus InAs ausgebildet sind und
die SCH-Schicht (20) aus GaAs ausgebildet ist.

5. Photohalbleitervorrichtung nach einem der vorhergehenden Ansprüche, bei der
die Quantenpunkte (22) eine aktive Schicht aus einem Halbleiterlichtverstärker sind.

6. Photohalbleitervorrichtung nach einem der Ansprüche 1 bis 1, bei der
die Quantenpunkte (22) eine aktive Schicht aus einem Halbleiterlaser sind.

7. Verfahren zur Herstellung einer Photohalbleitervorrichtung mit den Schritten:
Erzeugen mehrerer Quantenpunkte (22) von ungleichmäßiger Größe über ein Halbleitersubstrat (10), wobei die mehreren Quantenpunkte (22) in dreidimensional gewachsenen Inseln durch einen S-K-Modus selbstgebildet sind,
**dadurch gekennzeichnet, dass** die mehreren Quantenpunkte (22) so ausgebildet sind, dass, wenn die Fläche eines Strominjektionsbereichs (26) A ist und die Gesamtfläche der mehreren Quantenpunkte (22) B ist, das Flächenverhältnis B/A der mehreren Quantenpunkte (22) 0,4 oder weniger beträgt.

8. Verfahren zur Herstellung einer Photohalbleitervorricthung nach Anspruch 7, bei dem
im Schritt der Erzeugung von mehreren Quantenpunkten (22) die mehreren Quantenpunkte so erzeugt werden, dass das Flächenverhältnis B/A der mehreren Quantenpunkte (22) 0,1 beträgt.

9. Verfahren zur Herstellung einer Photohalbleitervorrichtung nach Anspruch 7 oder 8, das ferner den Schritt umfasst:
Erzeugen einer SCH-Schicht (20) aus einem Material mit einer Gitterkonstante, die kleiner als die der Quantenpunkte (22) ist, über dem Halbleitersubstrat. (10) vor dem Schritt der Erzeugung von Quantenpunkten (22).

## Revendications

1. Dispositif à semi-conducteur comprenant une pluralité de points quantiques (22),
la pluralité de points quantiques (22) ayant des dimensions non uniformes et étant dans des îlots à croissance tridimensionnelle auto-formés par un mode S-K ;
**caractérisé en ce que** lorsque la surface d'une région d'injection de courant (26) est A, et lorsque la surface totale de la pluralité de points quantiques (22) est B, le rapport de surface B/A de la pluralité de points quantiques (22) est 0,4, ou moins.

2. Dispositif à semi-conducteur selon la revendication 1, dans lequel le rapport de surface B/A de la pluralité de points quantiques (22) est 0,1.

3. Dispositif à semi-conducteur selon la revendication 1 ou la revendication 2, dans lequel :
les points quantiques (22) sont formés sur une couche de SCH (20) ; et
la constante de réseau d'un matériau des points quantiques (22) est plus importante que celle d'un matériau de la couche de SCH (20).

4. Dispositif à semi-conducteur selon les revendications 1, 2 ou 3, dans lequel :
les points quantiques (22) sont formés d'InAs ; et
la couche de SCH (20) est formée de GaAs.

5. Dispositif à semi-conducteur selon l'une quelconque des revendications précédentes, dans lequel :
les points quantiques (22) sont une couche active d'un amplificateur de lumière à semi-conducteur.

6. Dispositif à semi-conducteur selon l'une quelconque des revendications 1 à 4, dans lequel :
les points quantiques (22) sont une couche active d'un laser à semi-conducteur.

7. Procédé de fabrication d'un dispositif photoélectrique à semi-conducteur comprenant les étapes consistant à :
former une pluralité de points quantiques (22) d'une taille non uniforme sur un substrat semi-conducteur (10), la pluralité de points quantiques (22) étant auto-formés dans des îlots à croissance tridimensionnelle par mode S-K ;
**caractérisé en ce que** la pluralité de points quantiques (22) est formée de sorte que lorsque la surface d'une région d'injection de courant (26) est A, et lorsque la surface totale de la pluralité de points quantiques (22) est B, le rapport de surface B/A de la pluralité de points quantiques (22) est 0,4, ou moins.

8. Procédé de fabrication d'un dispositif photoélectrique à semi-conducteur selon la revendication 7, dans lequel :
dans l'étape consistant à former une pluralité de points quantiques (22), la pluralité de points quantiques est formée de sorte que le rapport de surface B/A de la pluralité de points quantiques (22) est 0,1.

9. Procédé de fabrication d'un dispositif photoélectrique à semi-conducteur selon les revendications 7 ou 8, comprenant en outre l'étape consistant à :
former une couche de SCH (20) d'un matériau ayant une constante de réseau plus petite que celle des points quantiques (22) sur le substrat semi-conducteur (10) avant l'étape consistant à former les points quantiques (22).
